# EUROPEAN PATENT SPECIFICATION

(11) **EP 4 597 140 B1**
(45) Date of publication and mention of the grant of the patent: **12.08.2026**
(21) Application number: 24174648.6
(22) Date of filing: 07.05.2024
(51) Int. Cl.: G01R 31/64, G01R 31/40

(54) **MONITORING MODULE AND METHOD OF MONITORING PERFORMANCE DEGRADATION OF CAPACITOR**
ÜBERWACHUNGSMODUL UND VERFAHREN ZUR ÜBERWACHUNG DER LEISTUNGSVERSCHLECHTERUNG EINES KONDENSATORS
MODULE DE SURVEILLANCE ET PROCÉDÉ DE SURVEILLANCE DE LA DÉGRADATION DE PERFORMANCE D'UN CONDENSATEUR

(30) Priority: 03.02.2024 IN 202441007411
(43) Date of publication of application: 06.08.2025
(73) Proprietor: Hitachi Energy Ltd, 8050 Zürich (CH)
(72) Inventor: BENGTSSON, Tord, 723 49 Västerås (SE); GHOSH, Riddhi, 72241 Västerås (SE); SCHUDERER, Juergen, 8047 Zürich (CH)
(74) Representative: Zacco Sweden AB

(56) References cited:
- WO-A1-2017/071754
- ASOODAR MOHSEN ET AL: "Online Health Monitoring of DC-Link Capacitors in Modular Multilevel Converters for FACTS and HVDC Applications", IEEE TRANSACTIONS ON POWER ELECTRONICS, INSTITUTE OF ELECTRICAL AND ELECTRONICS ENGINEERS, USA, vol. 36, no. 12, 24 June 2021 (2021-06-24), pages 13489 - 13503, XP011872855, ISSN: 0885-8993, [retrieved on 20210819], DOI: 10.1109/TPEL.2021.3091780

## Description

### TECHNICAL FIELD

The present disclosure generally relates to an online monitoring of capacitor performance. More particularly, it relates to providing a method to generate a signal for indicating performance degradation of the capacitor in a high voltage direct current, HVDC, power converter.

### BACKGROUND

Traditionally, capacitor performance degradation is assessed based on measuring capacitance and loss values of a capacitor. The capacitance and loss values of a capacitor are obtained by measuring voltage and current across the capacitor. Capacitors in HVDC power converters are expected to have very low losses and it becomes challenging to achieve precision online measurements required to detect such small losses, as sensor accuracy is generally much worse than the required measurement precision for capacitor signals.

In HVDC power converters, the capacitors are a critical part of the converters and store substantial energy. Any degradation in the capacitors may lead to service downtime and potential hazards. Therefore, monitoring individual capacitors in HVDC power converters is very crucial. Online monitoring for capacitor performance degradation in HVDC converters is challenging as voltage signal of capacitors in HVDC power converters comprises a small ripple on a high DC voltage, and switching scheme of capacitors in HVDC power converters may not have a repetitive pattern, which might limit the accuracy of standard frequency based analysis. WO2017071754A1 is related to a processing module and a method for use in conjunction with a capacitor included in a HVDC converter, for sensing failure or onset of failure of the capacitor.

Thus, there is a need for more robust signal analysis capability for online capacitor degradation assessment that can improve the overall reliability of capacitors in service.

### SUMMARY

It is therefore an object of the present disclosure to provide improved small signal analysis for online monitoring of capacitors to mitigate, alleviate, or eliminate all or at least some of the above-discussed drawbacks of presently known solutions.

This and other objects are achieved by means of a monitoring module, as defined in the appended claims. The term exemplary is in the present context to be understood as serving as an instance, example or illustration.

According to a first aspect of the present disclosure, a method of a monitoring module for generating a signal indicative of performance degradation of a capacitor in a HVDC power converter, wherein the monitoring module comprises a measuring unit operable to sample input load signals comprising voltage of the capacitor and current through the capacitor. The method comprises sampling input load signals of the capacitor using the measurement circuit, wherein the input load signals comprises capacitor voltage and current. The method further comprises calculating a capacitance value, C, of the capacitor using small signal analysis in the frequency domain using a frequency domain unit and the measured input load signals. The method further comprises calculating a power loss factor, PL, of the capacitor using small signal analysis in the time domain on the measured input load signals using a time domain unit. The method further comprises generating a signal, S, indicative of performance degradation of the capacitor based on the calculated capacitance value and the calculated power loss factor using a warning unit.

Advantageously, the small signal analysis identifies even small perturbations in the behaviour of the capacitor.

In some embodiments, the method further comprises calculating a capacitance value, C, of the capacitor using small signal analysis in the frequency domain based on processing the input load signals using standard discrete Fourier transform, DFT, and/or processing the input load signals using advanced high precision spectral analysis.

Advantageously, the small signal analysis obtains highly accurate estimation of peak characteristics such as amplitude and frequency in the frequency domain.

In some embodiments, the method further comprises calculating a power loss factor, PL, of the capacitor using small signal analysis in the time domain. The small signal analysis is based on processing the input load signals through parameter estimation from waveshape fitting, and/or processing the input load signals by probing specific signal features, wherein the specific signal features comprises voltage and current characteristics at specific intervals in the switching signal.

Advantageously, the small signal analysis in time domain is not computationally demanding and reduces noise.

In some embodiments, the method further comprises calculating a power loss factor, PL, of the capacitor using signal analysis in the time domain is performed using the capacitance value, C, calculated by the frequency domain unit.

In some embodiments, the method further comprises synchronizing the small signal analysis in the frequency domain unit and the time domain unit with a switching signal of the HVDC power converter.

According to a second aspect of the present disclosure, a monitoring module for generating a signal indicative of performance degradation of a capacitor in a HVDC power converter. The monitoring module comprises a measuring unit operable for sampling input load signals of the capacitor, wherein the input load signals comprises capacitor voltage and capacitor current. The monitoring module further comprises a frequency domain unit operable for calculating a capacitance value, C, of the capacitor using small signal analysis in the frequency domain using the measured input load signals. The monitoring module further comprises a time domain unit operable for calculating a power loss factor, PL, of the capacitor using small signal analysis in the time domain based on the measured input load signals. The monitoring module further comprises a warning unit operable for generating a signal, S, indicative of performance degradation of the capacitor based on the calculated capacitance value and the calculated power loss factor.

In some embodiments, the monitoring module further comprises configuring the frequency domain unit to analyse the input load signals using standard discrete Fourier transform, DFT, and/or analyse the input load signals using advanced high precision spectral analysis.

Advantageously, the monitoring module estimates capacitance value using the frequency domain unit with very small variation, thereby providing increased reliability in health monitoring of capacitors.

In some embodiments, the monitoring module further comprises configuring the time domain unit further to analyse the input load signals through parameter estimation from waveshape fitting, and/or analyse the input load signals by probing specific signal features, wherein the specific signal features comprises voltage and current characteristics at specific intervals in the switching signal.

Advantageously, the monitoring module accurately estimates power loss factor independent of signal repetition using the time domain unit, thereby providing increased reliability in health monitoring of capacitors.

In some embodiments, the monitoring module further comprises calculating a power loss factor, PL, of the capacitor using signal analysis in the time domain is performed using the capacitance value, C, calculated by the frequency domain unit.

In some embodiments, the monitoring module further comprises synchronizing the small signal analysis in the frequency domain unit and the time domain unit with a switching signal of the HVDC power converter.

According to a third aspect of the present disclosure a HVDC power converter comprises a capacitor, a control module comprising an output for a switching signal, and a monitoring module that is arranged to receive the switching signal from the control module.

In some embodiments, any of the above aspects may additionally have features identical with or corresponding to any of the various features as explained above for any of the other aspects.

Other advantages may be readily apparent to one having skill in the art. Certain embodiments may have some, or all of the recited advantages.

### BRIEF DESCRIPTION OF THE DRAWINGS

The foregoing will be apparent from the following more particular description of the example embodiments, as illustrated in the accompanying drawings in which like reference characters refer to the same parts throughout the different views. The drawings are not necessarily to scale, emphasis instead being placed upon illustrating the example embodiments.
- FIG. 1: discloses a schematic diagram of an example-monitoring module for generating a signal indicative of performance degradation of a capacitor;
- FIG. 2: is a flowchart illustrating example method steps for generating a signal indicative of performance degradation of a capacitor;
- FIG. 3: is a schematic block diagram illustrating an example HVDC power converter;
- FIG. 4a: discloses example results depicting average estimated capacitance from standard DFT; and
- FIG. 4b: discloses example results depicting estimated capacitance from spectral analysis;
- FIG. 5a: discloses example results depicting time fitting;
- FIG. 5b: discloses example results depicting average capacitor current for 20 and 100 period averages; and
- FIG. 6: discloses an example computing environment.

### DETAILED DESCRIPTION

Aspects of the present disclosure will be described more fully hereinafter with reference to the accompanying drawings. The apparatus disclosed herein can, however, be realized in many different forms and should not be construed as being limited to the aspects set forth herein. Like numbers in the drawings refer to like elements throughout.

The terminology used herein is for the purpose of describing particular aspects of the disclosure only and is not intended to limit the invention. It should be emphasized that the term "comprises/comprising" when used in this specification is taken to specify the presence of stated features, integers, steps, or components, but does not preclude the presence or addition of one or more other features, integers, steps, components, or groups thereof. As used herein, the singular forms "a", "an" and "the" are intended to include the plural forms as well, unless the context clearly indicates otherwise.

In general, traditional capacitor assessment is focused on two measured quantities i.e., capacitance and loss which are obtained by measuring voltage over and current through the capacitor. A common method to obtain the capacitance and loss is to measure the voltage over and the current through the capacitor as these are related by $I = C \frac{dU}{dt}$.

At a constant frequency of a voltage, the capacitance is obtained as $= \frac{\hat{I}}{2 πf \hat{U}}$, where *Î* and *Û* are the current and voltage amplitudes at frequency *f*. If the amplitudes are extracted as complex numbers, the loss is obtained as the imaginary part of the capacitance, otherwise only the magnitude of the capacitance, including loss, is obtained.

In general, HVDC power converters have multiple submodules or cells containing capacitors used to store and release energy. Individual cell capacitors help to shape a voltage waveform and smoothen transitions between different voltage levels. The individual cell capacitors are required to be carefully managed to ensure that each cell capacitor's voltage remains balanced, preventing over-voltage or under-voltage conditions. The voltage across each individual cell capacitor requires to be actively controlled to regulate the output voltage of the power converter. It is known in the art that control algorithms are used for maintaining balance and achieving the desired voltage levels. However, monitoring the cell capacitors individually in HVDC power converters is challenging as the voltage signal consists of a small voltage ripple on top of a high direct current, DC, voltage. Switching schemes in HVDC power converters may lack a repetitive pattern because of which the ripple voltage becomes non-periodic in nature, which makes it difficult to apply standard frequency based analysis techniques for measuring capacitance and loss factor of capacitors. Because of this lack of repetitive pattern, frequency domain approaches suffer from long or absent repetition times in the switching scheme as they require that the analysed signal is repetitive, which may not always be true.

Embodiments herein provide small signal analysis of the capacitor load signals as a basis for an alarm generation system for capacitor degradation in HVDC converters, wherein the small signal analysis identifies small perturbations in the behaviour of the capacitor without getting blinded by other dominating signals which enables to measure small voltage changes on top of a high DC voltage. Small signal analysis involves utilizing a minor portion of the entire data present within the signal, which facilitates to understand slight changes or disturbances with respect to a known steady state, without the need for complex non-linear analysis. Small signal analysis is therefore the information extracted from a signal and is just a fraction of the total information in that signal. Using the small signal analysis, relevant information-carrying small changes can be extracted without getting blinded by a huge dominating signal. The small signal analysis is advantageous in analysis of capacitor load signals as loss current in the capacitor is a very tiny fraction of the total current, while the voltage change due to leakage or a serial resistance is also a very small fraction of the total voltage change.

In some examples, the small signal analysis may be performed based on comparison with an expected waveform based on history, where the history is anything from a few cycles before to years before depending on application.

In some examples, the small signal analysis may be performed based on disregarding dominating frequencies where only certain critical frequencies are studied.

In some examples, the small signal analysis may be performed based on focusing on certain time instants or intervals where the desired information is more visible.

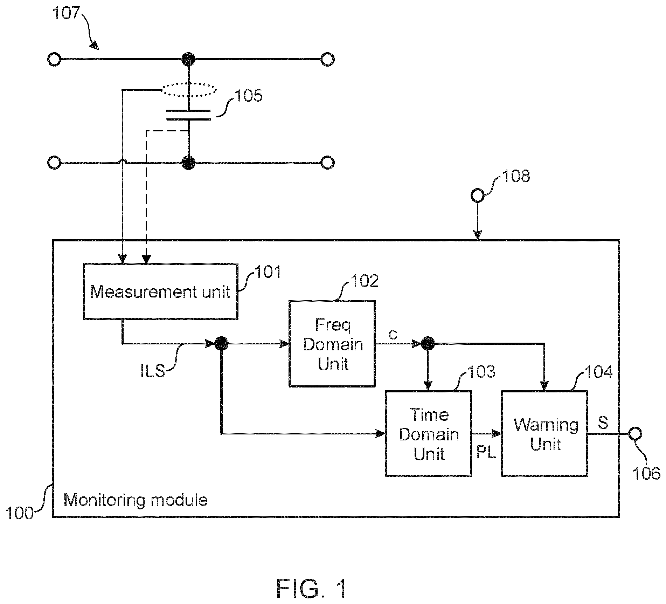

FIG. 1 discloses a schematic diagram of an example monitoring module 100 according to an embodiment of the present disclosure. The monitoring module 100 comprises a measurement unit 101, a frequency domain unit 102, a time domain unit 103, and a warning unit 104. The monitoring module 100 is connected to a capacitor 105 of a High Voltage Direct Current, HVDC power converter 107. Further, the monitoring module 100 is provided with a switching signal 108 that is controlling the HVDC converter 107. Furthermore, the monitoring module 100 is configured to generate a signal 106 indicative of performance degradation of the capacitor 105 of the HVDC power converter 107. The measurement unit 101 may be integral to the monitoring module 100 for allowing comprehensive assessment of different parameters related to different measurements. The measurement unit 101 is configured to sample input load signal, ILS, comprising voltage of the capacitor 105 and total current through the capacitor 105.

In some examples, the capacitor 105 may comprise one of a Direct current, DC link capacitor, a filter capacitor, a voltage snubbing capacitor, or a DC smoothing capacitor.

The frequency domain unit 102 is used for estimating capacitance, C of the capacitor 105 based on processing the sampled ILS from the measurement unit 101.

Time domain unit 103 is used for estimating power loss factor, PL, of the capacitor 105 based on processing the sampled ILS from the measurement unit 101.

In some embodiments, the time domain unit 103 may use the capacitance value, C, estimated by the frequency domain unit 102 for estimating PL of the capacitor 105.

The warning unit 105 generates a signal, S, which is indicative of the performance degradation of the capacitor 105. The signal, S, is calculated using the estimated capacitance value, C, and the estimated power loss factor, PL.

Therefore, according to embodiments of the present disclosure, the monitoring module 100 is provided to perform small signal analysis of capacitor load signals for identifying small perturbations in the behaviour of the capacitor 105 of the HVDC power converter 107, which may then be used as a basis for generating an alarm for capacitor performance degradation.

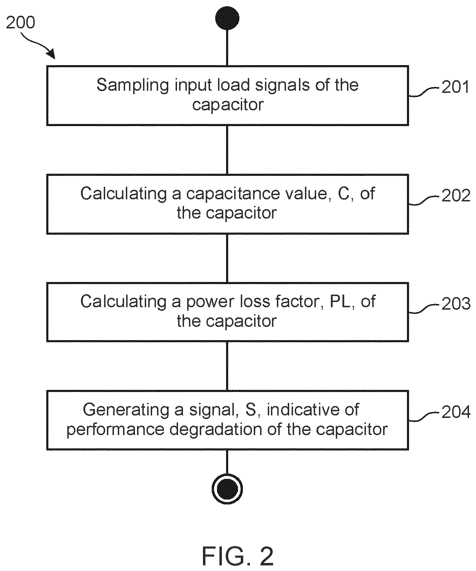

FIG. 2 is a flowchart illustrating example method steps of a method 200 performed for generating the signal 106 indicative of performance degradation of the capacitor 105 in the HVDC power converter 107. The method 200 is performed through the monitoring module 100 configured to generate the signal 106 indicative of performance degradation of the capacitor 105 of the HVDC power converter 107.

At step 201, the method 200 comprises sampling 201 input load signals of the capacitor 105 using the measurement circuit 101, wherein the input load signals comprises capacitor voltage and current.

At step 202, the method 200 comprises calculating a capacitance value, C, of the capacitor 105 using the small signal analysis in the frequency domain by using the frequency domain unit 102 and the measured input load signals.

In some embodiments, the frequency domain unit 102 may analyse the ILS using standard discrete Fourier transform, DFT. A one-period DFT is used to obtain phasors of current and voltage from the ILS. The DFT phasor calculation extracts fundamental frequency phasors. To improve capacitance estimation in view of variations in standard DFT, the capacitance, C, and power loss factor, PL, may be estimated from averaged current and voltage phasors within few percent of variation.

In some embodiments, the frequency domain unit 102 may analyse the ILS using advanced spectral analysis, where phasor extraction may have good accuracy depending on peak-to-noise ratio.

In an example, a window function may be applied to the ILS before performing the Fast Fourier Transform, FFT, to minimize leakage effects that can occur when analysing a finite segment of a signal.

In an example, peak interpolation may be applied to the ILS after FFT to obtain more accurate amplitude and frequency values compared to just using the largest value of FFT bin sequence. The peak interpolation includes fitting a model, often a parabola, to the peaks in the frequency domain to obtain accurate estimation of peak characteristics such as amplitude and frequency.

In an example, a Gaussian window may be applied to the ILS before FFT to minimize the combined peak width in both frequency and time domains.

In some embodiments, the application of peak interpolation to the ILS after FFT may be combined with application of a Gaussian window to the ILS before FFT to use many more bins for fitting three important parameters of the peak i.e., amplitude, phase and frequency, thereby obtaining highly accurate estimation.

At step 203, the method 200 comprises calculating the power loss factor, PL, of the capacitor 105 using small signal analysis in the time domain on the measured input load signals and the calculated capacitance value using the time domain unit 103.

In some embodiments, the time domain unit 103 may use the capacitance value, C, estimated by the frequency domain unit 102 for estimating PL of the capacitor 105.

In some embodiments, the time domain unit 103 may use average capacitor current to evaluate capacitor condition by relying on long signal lengths rather than on signal repetition. Here, when the capacitor voltage is constant, the average current may be zero if there is no power loss. Furthermore, the ratio of average current to root mean square, RMS, current may be closely related to the loss factor, which makes interpretation of capacitor parameters simple.

In some embodiments, the time domain unit 104 may use specific parts of the ILS signal for analysis, wherein the specific parts of the signal may be independent of repeating nature of signals such as using load signals through the capacitor during switching intervals or switching instant.

In some embodiments, the time domain unit 104 may use a time fitting technique for capacitor estimation. Time fitting is a model-based technique using an expression for the relation between the observed signals. For a capacitor with loss, the loss can be modelled as a parallel resistance, where the relation between voltage and current of the capacitor 105 of the HVDC power converter 107 is given by $= C \frac{dU}{dt} + \frac{U}{R}$. With U and I measured, C and R can be found by fitting the observed currents and voltage samples according to this equation. In view of increase in noise, the above equation can be integrated to yield $\int Idt = CU + \frac{1}{R} \int U dt + const$ , wherein the constant arises due to integration. With this formulation, the data to be fitted is less noisy and the expression to be fitted becomes *z = a x + by + c* 1 where z is integrated capacitor current, x is cell voltage and y is integrated cell voltage, and 1 is a vector of the same length filled with 1^{s}. As the fitting is effectively made with an extended least square fit, it is not very computationally demanding and also reduces noise.

At step 204, the method 200 comprises generating 204 the signal, S, indicative of performance degradation of the capacitor 105 based on the calculated capacitance value and the calculated power loss factor using a warning unit 104.

In an example, the signal, S, can be an alarm or a warning generated as a result of the capacitance drop by a certain predefined percentage or a change in resistance or loss factor by a certain predefined factor. Such an alarm or a warning can be based on capacitance or loss factor changes of individual capacitors beyond predefined thresholds, or can be based on some statistical measure based on the capacitance and loss factor of all capacitors in the converter to detect outliers. The signal, S, can also consist of control and protection actions initiated to disconnect the degraded capacitor.

Thus, the method 200 provides an online capacitor performance degradation assessment without the need for any specialized hardware or operational steps.

Various embodiments for enabling estimation of capacitance, C, and power loss factor, PL, of the capacitor 105 are explained in conjunction with figures in the later parts of the description.

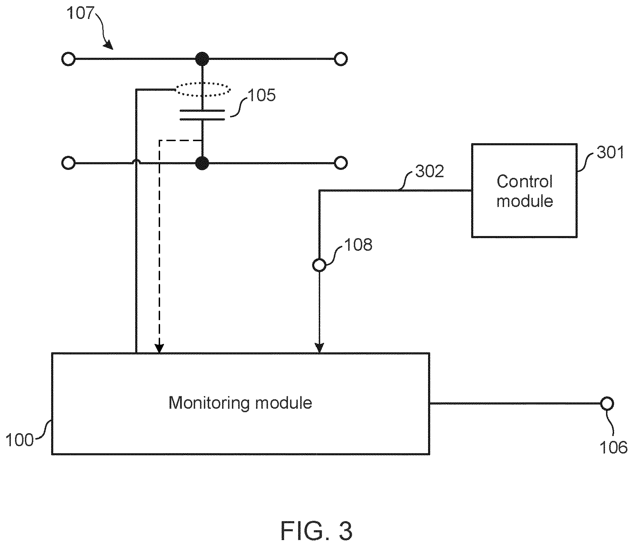

FIG. 3 discloses a schematic block diagram illustrating an example HVDC power converter 107. As shown in FIG. 3, the HVDC power converter 107 comprises the capacitor 105, a control module 301 comprising an output 302 for switching signal, and the monitoring module 100 that is arranged to receive the switching signal 302 from the control module 301.

The capacitor 105 may be a capacitor cell of multiple series connected capacitor cell of the HVDC power converter 107, where the series connection of the capacitor cells allows the converter to achieve high-voltage levels and efficient power transmission over long distances. Each cell comprises a cell controller, switches, a capacitor and auxiliary components. The cell controller has provisions to read the voltage and current in the cell, which is used for certain control and monitoring functions, wherein a main controller determines the overall switching scheme depending on the present system demands and other circumstances. The main controller sends switching commands to the cells.

In some examples, the monitoring module 100 may be a code module in the cell controller.

In some examples, the monitoring module 100 may be executed in the main controller.

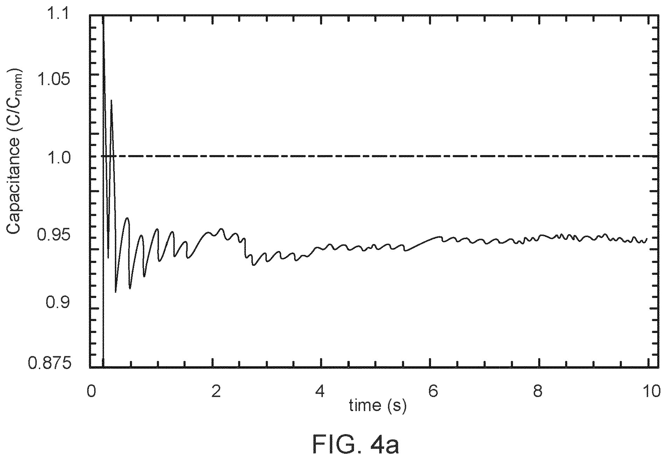

FIG. 4a discloses example results depicting average estimated capacitance from standard DFT. Standard DFT phasor calculation is used to extract fundamental frequency phasors of ILS that may deviate from the nominal frequency, which may be 50 Hz. In view that direct DFT results vary a lot due to noise, averaging may be used to reduce the variation. While it is noted that averaging is equivalent to applying a multi-period DFT, it is found that the capacitance is estimated within a few percent of variation. The capacitance, C, is estimated from the averaged current and voltage phasors by $= \frac{\hat{I}}{2 πf \hat{U}}$, and the results are as shown in FIG. 4a. As shown in FIG. 4a, the dotted line represents expected values, whereas solid line represents variations in estimated capacitance. It is evident from FIG. 4a that capacitance is estimated within a few percent of variation (five percent absolute error due to deviation in sensor accuracy, but only approximately one percent variation) for the 100 period average, where the one percent variation indicates that readings may vary within a one percent range over time or under different conditions.

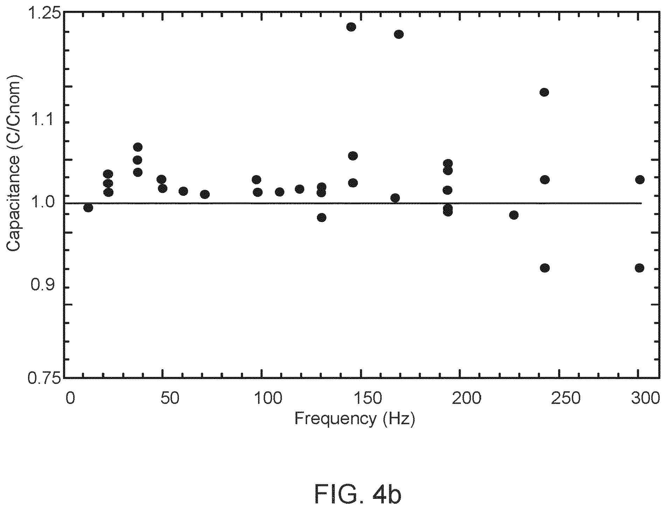

FIG. 4b discloses example results depicting estimated capacitance at different frequencies from spectral analysis based on Gaussian window in Fast Fourier Transform, FFT. The spectral analysis is used to extract phasors of ILS based on high precision, simultaneous analysis of harmonically unrelated frequencies, and the use of a Gaussian window to reduce sidelobes in the spectra. Here, in spectral analysis, long records of a signal are analysed to provide more data points while also improving frequency resolution in the resulting spectrum. Also, longer records allow for a more detailed examination of the frequency content. A Gaussian window provides better frequency resolution by reducing sidelobes, which improve the accuracy of frequency estimation, which in turn make it easier to distinguish closely spaced frequencies.

As shown in FIG. 4b, the line represents true capacitance, whereas the bubbles represents capacitance estimation. Though Gaussian window in FFT is preferred, the spectral analysis may be performed using windows such as, but not limited to, Hanning, Hamming, Blackman-Harris, or Flat top.

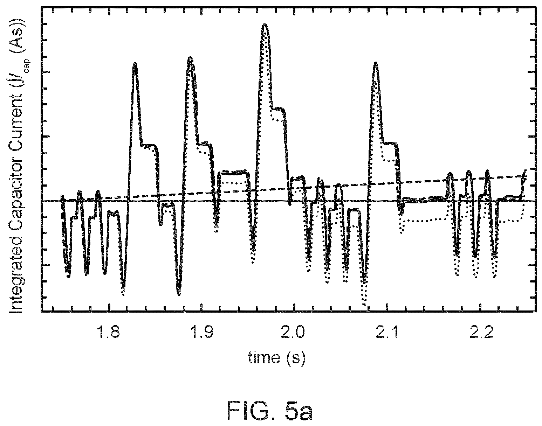

FIG. 5a discloses example results depicting time fitting for capacitor estimation through the monitoring module 100. Power loss, PL, of the capacitor is modelled as a parallel resistance based on relation between voltage and current of the capacitor 105 of the HVDC converter 107, wherein the relation is given by $= C \frac{dU}{dt} + \frac{U}{R}$. After measuring U and I, C and R may be determined by fitting the observed current and voltage samples of the capacitor according to the above relation. Further, because there might be limited accuracy while using derivatives of signals because of noise, the above relation is integrated to yield $\int Idt = CU + \frac{1}{R} \int U dt + const$ . Thereafter, the expression to be fitted becomes *z = a x + b y + c* 1 where z is integrated capacitor current, x is cell voltage and y is integrated cell voltage, and 1 is a vector of the same length filled with 1^{s}. As shown in FIG. 5a, trend line indicates resistive contribution, continuous sequence indicates pure capacitive contribution, dotted sequence indicates fit line, and dashed sequence indicates current integral.

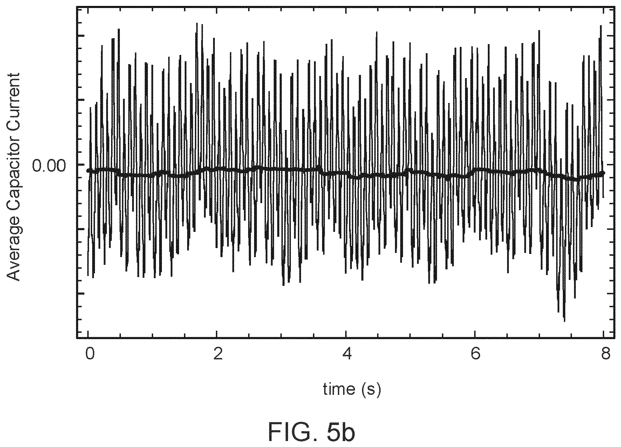

FIG. 5b discloses example results depicting average capacitor current for 20 and 100 period averages. As shown in FIG. 5b, the average current is shown in two different averaging lengths, where sequence indicated with light line indicates 20 period average and sequence indicated with dark line indicates 100 period average. The result as shown in FIG. 5b has a very small variation while averaging over 100 periods, close to expected capacitor power loss.

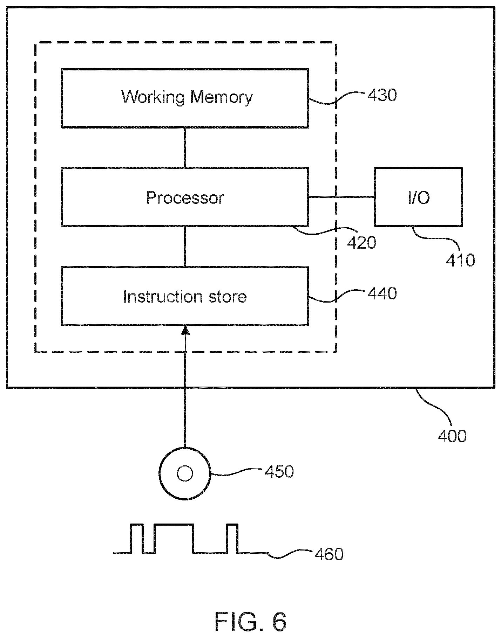

FIG. 6 shows an exemplary implementation of the monitoring module 100, in programmable signal processing hardware. The signal processing apparatus 400 shown in FIG. 6 comprises an input/output (I/O) section 410 for receiving input load signals and output the signal. The signal processing apparatus 400 further comprises a processor 420, a working memory 430 and an instruction store 440 storing computer-readable instructions which, when executed by the processor 420, cause the processor 420 to perform the processing operations hereinafter described to control the monitoring module 100. The instruction store 440 may comprise a ROM which is pre-loaded with the computer-readable instructions. Alternatively, the instruction store 440 may comprise a RAM or similar type of memory, and the computer readable instructions can be input thereto from a computer program product, such as a computer-readable storage medium 450 such as a CD-ROM, etc. or a computer-readable signal 460 carrying the computer-readable instructions.

The hardware components shown in FIG. 6, comprising the processor 420, the working memory 430 and the instruction store 440, are configured to implement the functionality of the aforementioned monitoring module 100 described in FIG. 1. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the scope of the disclosure, as defined by the appended claims.

## Claims

1. A method (200) of monitoring a capacitor (105) in a High Voltage Direct Current, HVDC, power converter (107), wherein the monitoring is performed by a monitoring module (100) that comprises a measuring unit (101) operable to sample input load signals comprising voltage of the capacitor and current through the capacitor, the method (200) comprising:
sampling (201) input load signals of the capacitor using the measurement unit (101), wherein the input load signals comprises capacitor voltage and current; wherein the method is **characterised by**:
calculating (202) a capacitance value, C, of the capacitor using small signal analysis in the frequency domain using a frequency domain unit (102) and the measured input load signals;
calculating (203) a power loss factor, PL, of the capacitor using small signal analysis in the time domain on the measured input load signals using a time domain unit (103); and
generating (204) a signal, S, indicative of performance degradation of the capacitor (105) based on the calculated capacitance value and the calculated power loss factor.

2. The method (200) of claim 1, wherein the step of calculating (202) a capacitance value, C, of the capacitor using small signal analysis in the frequency domain comprises:
processing the input load signals using standard discrete Fourier transform (DFT); and/or
processing the input load signals using advanced high precision spectral analysis.

3. The method (200) according to any one of claims 1 or 2, wherein the step of calculating (203) a power loss factor, PL, of the capacitor using small signal analysis in the time domain comprises:
processing the input load signals through parameter estimation from waveshape fitting; and/or
processing the input load signals by probing specific signal features, wherein the specific signal features comprises voltage and current characteristics at specific intervals in the switching signal.

4. The method (200) according to any one of claims 1 or 3, wherein the step of calculating (203) a power loss factor, PL, of the capacitor using signal analysis in the time domain is performed using the capacitance value, C, calculated by the frequency domain unit (102).

5. The method (200) according to any of the preceding claims, wherein the small signal analysis in the frequency domain unit (102) and the time domain unit (103) is synchronized with a switching signal (108) of the HVDC power converter (107).

6. A monitoring module (100) for generating a signal (106) indicative of performance degradation of a capacitor (105) in a High Voltage Direct Current, HVDC, power converter (107), wherein the monitoring module (100) comprises:
a measuring unit (101) operable for sampling (201) input load signals of the capacitor, wherein the input load signals comprises capacitor voltage and capacitor current; wherein the monitoring module is **characterised by**:
a frequency domain unit (102) operable for calculating (202) a capacitance value, C, of the capacitor using small signal analysis in the frequency domain using the measured input load signals;
a time domain unit (103) operable for calculating (203) a power loss factor, PL, of the capacitor using small signal analysis in the time domain based on the measured input load signals; and
a warning unit (104) operable for generating (204) a signal, S, indicative of performance degradation of the capacitor (105) based on the calculated capacitance value and the calculated power loss factor.

7. The monitoring module (100) according to claim 6, wherein the frequency domain unit further is configured to:
process the input load signals using standard discrete Fourier transform (DFT); and/or
process the input load signals using advanced high precision spectral analysis.

8. The monitoring module (100) according to any one of claims 6 or 7, wherein the time domain unit further is configured to:
process the input load signals through parameter estimation from waveshape fitting; and/or
process the input load signals by probing specific signal features, wherein the specific signal features comprises voltage and current characteristics at specific intervals in the switching signal.

9. The monitoring module (100) according to any one of claims 6 or 8, wherein the step of calculating (203) a power loss factor, PL, of the capacitor using signal analysis in the time domain is performed using the capacitance value, C, calculated by the frequency domain unit (102).

10. The monitoring module (100) according to any of the preceding claims, wherein the small signal analysis in the frequency domain unit (102) and the time domain unit (103) is synchronized with a switching signal (108) of the HVDC power converter (107).

11. A High Voltage Direct Current, HVDC, power converter (107), comprising:
a capacitor (105);
a control module (301) comprising an output (302) for a switching signal;
a monitoring module (100) according to any one of claim 6 to 10, wherein the monitoring module is arranged to receive the switching signal (302) from the control module (301).

12. A computer-readable storage medium (450) storing computer program instructions which, when executed by a processor (420) , cause the processor (420) to perform a method as set out in at least one of claims 1 to 5.

13. A signal (460) carrying computer program instructions which, when executed by a processor (420), cause the processor (420) to perform a method as set out in at least one of claims 1 to 5.

## Patentansprüche

1. Verfahren (200) zum Überwachen eines Kondensators (105) in einem Stromrichter (107) für Hochspannungsgleichstrom, HVDC, wobei das Überwachen durch ein Überwachungsmodul (100) durchgeführt wird, das eine Messeinheit (101) umfasst, die dazu betreibbar ist, Eingangslaststsignale abzutasten, die die Spannung des Kondensators und den Strom durch den Kondensator umfassen, wobei das Verfahren (200) umfasst:
Abtasten (201) von Eingangslastsignalen des Kondensators unter Verwendung der Messeinheit (101), wobei die Eingangslastsignale die Kondensatorspannung und den Kondensatorstrom umfassen; wobei das Verfahren **gekennzeichnet ist durch**:
Berechnen (202) eines Kapazitätswerts, C, des Kondensators unter Verwendung einer Kleinsignalanalyse im Frequenzbereich unter Verwendung einer Frequenzbereichseinheit (102) und der gemessenen Eingangslastsignale;
Berechnen (203) eines Leistungsverlustfaktors, PL, des Kondensators unter Verwendung einer Kleinsignalanalyse im Zeitbereich der gemessenen Eingangslastsignale unter Verwendung einer Zeitbereichseinheit (103); und
Generieren (204) eines Signals, S, das einen Leistungsabbau des Kondensators (105) anzeigt, basierend auf dem berechneten Kapazitätswert und dem berechneten Leistungsverlustfaktor.

2. Verfahren (200) nach Anspruch 1, wobei der Schritt des Berechnens (202) eines Kapazitätswerts, C, des Kondensators unter Verwendung einer Kleinsignalanalyse im Frequenzbereich umfasst:
Verarbeiten der Eingangslastsignale unter Verwendung einer standardmäßigen Diskrete-Fourier-Transformation (DFT); und/oder
Verarbeiten der Eingangslastsignale unter Verwendung einer erweiterten hochpräzisen Spektralanalyse.

3. Verfahren (200) nach einem der Ansprüche 1 oder 2, wobei der Schritt des Berechnens (203) eines Leistungsverlustfaktors, PL, des Kondensators unter Verwendung einer Kleinsignalanalyse im Zeitbereich umfasst:
Verarbeiten der Eingangslastsignale durch Parameterschätzung aus einer Wellenformanpassung; und/oder
Verarbeiten der Eingangslastsignale durch Abtasten spezifischer Signalmerkmale, wobei die spezifischen Signalmerkmale Spannungs- und Stromcharakteristiken zu spezifischen Intervallen im Schaltsignal umfassen.

4. Verfahren (200) nach einem der Ansprüche 1 oder 3, wobei der Schritt des Berechnens (203) eines Leistungsverlustfaktors, PL, des Kondensators unter Verwendung einer Signalanalyse im Zeitbereich unter Verwendung des Kapazitätswerts, C, durchgeführt wird, der durch die Frequenzbereichseinheit (102) berechnet wurde.

5. Verfahren (200) nach einem der vorhergehenden Ansprüche, wobei die Kleinsignalanalyse in der Frequenzbereichseinheit (102) und der Zeitbereichseinheit (103) mit einem Schaltsignal (108) des HVDC-Stromrichters (107) synchronisiert ist.

6. Überwachungsmodul (100) zur Generierung eines Signals (106), das einen Leistungsabbau eines Kondensators (105) in einem Stromrichter (107) für Hochspannungsgleichstrom, HVDC, anzeigt, wobei das Überwachungsmodul (100) umfasst:
eine Messeinheit (101), die dazu betreibbar ist, Eingangslastsignale des Kondensators abzutasten (201), wobei die Eingangslastsignale die Kondensatorspannung und den Kondensatorstrom umfassen; wobei das Überwachungsmodul **gekennzeichnet ist durch**:
eine Frequenzbereichseinheit (102), die dazu betreibbar ist, einen Kapazitätswert, C, des Kondensators unter Verwendung einer Kleinsignalanalyse im Frequenzbereich unter Verwendung der gemessenen Eingangslastsignale zu berechnen (202);
eine Zeitbereichseinheit (103), die dazu betreibbar ist, einen Leistungsverlustfaktor, PL, des Kondensators unter Verwendung einer Kleinsignalanalyse im Zeitbereich basierend auf den gemessenen Eingangslastsignalen zu berechnen (203); und
eine Warneinheit (104), die dazu betreibbar ist, ein Signal, S, zu generieren (204), das einen Leistungsabbau des Kondensators (105) anzeigt, basierend auf dem berechneten Kapazitätswert und dem berechneten Leistungsverlustfaktor.

7. Überwachungsmodul (100) nach Anspruch 6, wobei die Frequenzbereichseinheit ferner dazu ausgelegt ist:
Verarbeiten der Eingangslastsignale unter Verwendung einer standardmäßigen Diskrete-Fourier-Transformation (DFT); und/oder
Verarbeiten der Eingangslastsignale unter Verwendung einer erweiterten hochpräzisen Spektralanalyse.

8. Überwachungsmodul (100) nach einem der Ansprüche 6 oder 7, wobei die Zeitbereichseinheit ferner dazu ausgelegt ist:
Verarbeiten der Eingangslastsignale durch Parameterschätzung aus einer Wellenformanpassung; und/oder
Verarbeiten der Eingangslastsignale durch Abtasten spezifischer Signalmerkmale, wobei die spezifischen Signalmerkmale Spannungs- und Stromcharakteristiken zu spezifischen Intervallen im Schaltsignal umfassen.

9. Überwachungsmodul (100) nach einem der Ansprüche 6 oder 8, wobei der Schritt des Berechnens (203) eines Leistungsverlustfaktors, PL, des Kondensators unter Verwendung einer Signalanalyse im Zeitbereich unter Verwendung des Kapazitätswerts, C, durchgeführt wird, der durch die Frequenzbereichseinheit (102) berechnet wurde.

10. Überwachungsmodul (100) nach einem der vorhergehenden Ansprüche, wobei die Kleinsignalanalyse in der Frequenzbereichseinheit (102) und der Zeitbereichseinheit (103) mit einem Schaltsignal (108) des HVDC-Stromrichters (107) synchronisiert ist.

11. Stromrichter (107) für Hochspannungsgleichstrom, HVDC, umfassend:
einen Kondensator (105);
ein Steuermodul (301), das einen Ausgang (302) für ein Schaltsignal umfasst;
ein Überwachungsmodul (100) nach einem der Ansprüche 6 bis 10, wobei das Überwachungsmodul dazu angeordnet ist, das Schaltsignal (302) von dem Steuermodul (301) zu empfangen.

12. Computerlesbares Speichermedium (450), das Computerprogrammanweisungen speichert, die, wenn sie durch einen Prozessor (420) ausgeführt werden, den Prozessor (420) veranlassen, ein Verfahren gemäß mindestens einem der Ansprüche 1 bis 5 durchzuführen.

13. Signal (460), das Computerprogrammanweisungen trägt, die, wenn sie durch einen Prozessor (420) ausgeführt werden, den Prozessor (420) veranlassen, ein Verfahren gemäß mindestens einem der Ansprüche 1 bis 5 durchzuführen.

## Revendications

1. Procédé (200) de surveillance d'un condensateur (105) dans un convertisseur de puissance (107) à courant continu haute tension, CCHT, dans lequel la surveillance est réalisée par un module de surveillance (100) qui comprend une unité de mesure (101) fonctionnelle pour échantillonner des signaux de charge d'entrée comprenant la tension du condensateur et le courant traversant le condensateur, le procédé (200) comprenant :
l'échantillonnage (201) de signaux de charge d'entrée du condensateur à l'aide de l'unité de mesure (101), dans lequel les signaux de charge d'entrée comprennent la tension et le courant de condensateur ; dans lequel le procédé est **caractérisé par** :
le calcul (202) d'une valeur de capacité, C, du condensateur à l'aide d'une analyse de petits signaux dans le domaine fréquentiel à l'aide d'une unité de domaine fréquentiel (102) et des signaux de charge d'entrée mesurés ;
le calcul (203) d'un facteur de perte de puissance, PL, du condensateur à l'aide d'une analyse de petits signaux dans le domaine temporel sur les signaux de charge d'entrée mesurés à l'aide d'une unité de domaine temporel (103) ; et
la génération (204) d'un signal, S, indicatif d'une dégradation de performance du condensateur (105) sur la base de la valeur de capacité calculée et du facteur de perte de puissance calculé.

2. Procédé (200) selon la revendication 1, dans lequel l'étape de calcul (202) d'une valeur de capacité, C, du condensateur à l'aide d'une analyse de petits signaux dans le domaine fréquentiel comprend :
le traitement des signaux de charge d'entrée à l'aide d'une transformée de Fourier discrète (TFD) standard ; et/ou
le traitement des signaux de charge d'entrée à l'aide d'une analyse spectrale avancée de haute précision.

3. Procédé (200) selon l'une quelconque des revendications 1 ou 2, dans lequel l'étape de calcul (203) d'un facteur de perte de puissance, PL, du condensateur à l'aide d'une analyse de petits signaux dans le domaine temporel comprend :
le traitement des signaux de charge d'entrée par une estimation de paramètres à partir d'un ajustement de forme d'onde ; et/ou
le traitement des signaux de charge d'entrée par une estimation de paramètres à partir d'un ajustement de forme d'onde ; et/ou

4. Procédé (200) selon l'une quelconque des revendications 1 ou 3, dans lequel l'étape de calcul (203) d'un facteur de perte de puissance, PL, du condensateur à l'aide d'une analyse de signal dans le domaine temporel est réalisée en utilisant la valeur de capacité, C, calculée par l'unité de domaine fréquentiel (102).

5. Procédé (200) selon l'une quelconque des revendications précédentes, dans lequel l'analyse de petits signaux dans l'unité de domaine fréquentiel (102) et l'unité de domaine temporel (103) est synchronisée avec un signal de commutation (108) du convertisseur de puissance (107) à CCHT.

6. Module de surveillance (100) pour générer un signal (106) indicatif d'une dégradation de performance d'un condensateur (105) dans un convertisseur de puissance (107) à courant continu haute tension, CCHT, dans lequel le module de surveillance (100) comprend :
une unité de mesure (101) fonctionnelle pour l'échantillonnage (201) de signaux de charge d'entrée du condensateur, dans lequel les signaux de charge d'entrée comprennent une tension de condensateur et un courant de condensateur ; dans lequel le module de surveillance est **caractérisé par** :
une unité de domaine fréquentiel (102) fonctionnelle pour calculer (202) une valeur de capacité, C, du condensateur à l'aide d'une analyse de petits signaux dans le domaine fréquentiel à l'aide des signaux de charge d'entrée mesurés ;
une unité de domaine temporel (103) fonctionnelle pour calculer (203) un facteur de perte de puissance, PL, du condensateur à l'aide d'une analyse de petits signaux dans le domaine temporel sur la base des signaux de charge d'entrée mesurés ; et
une unité d'avertissement (104) fonctionnelle pour générer (204) un signal, S, indicatif d'une dégradation de performance du condensateur (105) sur la base de la valeur de capacité calculée et du facteur de perte de puissance calculé.

7. Module de surveillance (100) selon la revendication 6, dans lequel l'unité de domaine fréquentiel est en outre configurée pour :
traiter les signaux de charge d'entrée à l'aide d'une transformée de Fourier discrète (TFD) standard ; et/ou
traiter les signaux de charge d'entrée à l'aide d'une analyse spectrale avancée de haute précision.

8. Module de surveillance (100) selon l'une quelconque des revendications 6 ou 7, dans lequel l'unité de domaine temporel est en outre configurée pour :
traiter les signaux de charge d'entrée par une estimation de paramètres à partir d'un ajustement de forme d'onde ; et/ou
traiter les signaux de charge d'entrée par sondage de caractéristiques de signal spécifiques, dans lequel les caractéristiques de signal spécifiques comprennent des caractéristiques de tension et de courant à des intervalles spécifiques dans le signal de commutation.

9. Module de surveillance (100) selon l'une quelconque des revendications 6 ou 8, dans lequel l'étape de calcul (203) d'un facteur de perte de puissance, PL, du condensateur à l'aide d'une analyse de signal dans le domaine temporel est réalisée en utilisant la valeur de capacité, C, calculée par l'unité de domaine fréquentiel (102).

10. Module de surveillance (100) selon l'une quelconque des revendications précédentes, dans lequel l'analyse de petits signaux dans l'unité de domaine fréquentiel (102) et l'unité de domaine temporel (103) est synchronisée with un signal de commutation (108) du convertisseur de puissance (107) à CCHT.

11. Convertisseur de puissance (107) à courant continu haute tension, CCHT, comprenant :
un condensateur (105) ;
un module de commande (301) comprenant une sortie (302) pour un signal de commutation ;
un module de surveillance (100) selon l'une quelconque des revendications 6 à 10, dans lequel le module de surveillance est agencé pour recevoir le signal de commutation (302) provenant du module de commande (301).

12. Support de stockage lisible par ordinateur (450) stockant des instructions de programme informatique qui, lorsqu'elles sont exécutées par un processeur (420), amènent le processeur (420) à réaliser un procédé tel qu'énoncé dans au moins une des revendications 1 à 5.

13. Signal (460) acheminant des instructions de programme informatique qui, lorsqu'elles sont exécutées par un processeur (420), amènent le processeur (420) à réaliser un procédé tel qu'énoncé dans au moins une des revendications 1 à 5.
